# EUROPEAN PATENT APPLICATION

(11) **EP 0 636 893 A2**
(43) Date of publication of application: **01.02.1995**
(21) Application number: 93830360.9
(22) Date of filing: 02.09.1993
(51) Int. Cl.: G01R 31/02, G01R 19/165, H01R 13/66

(54) **Circuit device for visually signalling leakage currents from an electric system to earth**

(30) Priority: 30.07.1993 IT MI931750
(71) Applicant: Gallone, Cesare, Camberley, Surrey (GB)
(72) Inventor: Gallone, Cesare, Camberley, Surrey (GB)
(74) Representative: Righetti, Giuseppe

(57) **Abstract**

A circuit device for visually signalling leakage currents from an electric system to earth essentially consists of a differential magnetic flux detector (3) for detecting the difference between the magnetic flux interwound with the input conductor of the electric system feeding line and the flux interwound with the output conductor of the same feeding line, said detector (3) being connected to a plurality of selective comparators (6, 7, 8, 9, 10) for selection of the absorption current, each of which acts within given thresholds of a division scale of the absorption currents and is associated with a corresponding luminous indicator (11, 12, 13, 14, 15) signalling the detected absorption.

## Description

The present invention relates to a device for visually signalling leakage currents from an electric system to earth.

It is known that in domestic and industrial electric systems the so-called "common earthing or grounding" is imposed both for meeting the provisions of law in the matter and for technical reasons.

In fact a precise grounding installation is imposed by law, and all domestic and industrial apparatus as well as the electric system proper must be conformed to it from a constructional and operational point of view in order to protect an operator against possible electrical discharges and also safeguard the apparatus themselves (above all if they are of the electronic type) against anomalous currents and/or disturbance voltages.

Grounding or earthing is made by one suitably-shaped metal body or a plurality of them. Said bodies are usually named "ground electrodes" and are embedded in the earth for establishing an appropriate galvanic connection.

Ground electrodes are then connected, through appropriate collectors, to a plurality of ground conductors in turn connected to respective parts of the electric system.

By so doing all electric currents that may be conducted to earth due to a failure in the insulation of an apparatus or system are dissipated into the earth, said currents being referred to as leakage currents.

In many cases the earth is also utilized for permanently connecting all points of an electric circuit that in operation "closes" to ground.

Therefore "grounding or earthing" means to physically connect an electric system or given parts of an apparatus to a ground for the purpose of keeping the potential of that system or apparatus parts to a fixed reference value. In other cases the earth connection aims at preventing given parts of an apparatus usually unenergized from taking dangerous potentials, for lack of insulation or other reasons.

It is therefore very important to know and detect leakage currents to the earth. In fact the presence of leakage currents means that a bad insulation exists or, in other cases, it is evidence of an irregular operation of an apparatus (closed to ground).

In the connection it is to be pointed out that a leakage current is established when, due to any accidental reason (bad insulation, failure, etc.) one part that is not to be energized, such as the metal framework of a machine or an electric board is on the contrary subjected to a potential difference. In this case there is a leakage in an electric system with a earthing referred to as a protective one.

A leakage current also is established when, due to an anomalous cause, there is a current circulation at circuit points and/or in equipments usually grounded (that is using the ground as the return conductor for operation), but this current is a current induced by other currents that "close" at other circuit points connected to a ground. Typical cases are for example represented by lighting rods and tram rails.

Based on the foregoing, it is necessary to continuously inspect, in any wiring system, by appropriate devices whether anomalous leakage currents are generated in the system itself or any connected equipment, which leakage currents can produce severe injuries to the thinks and/or persons directly.

More particularly, it is important to know in which part of the system a possible bad insulation (and therefore a given leakage current) exists or which electrical (domestic and/or industrial) equipment absorbs an anomalous leakage current. All that is necessary both for preventive purposes, in order to verify whether the system complies with the requirements of law, and for achieving an efficient servicing activity so that the apparatus and/or equipment point causing irregularities in a correct operation may be detected quickly and without doubt.

At the present state of the art no device exists which is capable of detecting an anomalous current absorption by visually signalling it by means of luminous points and which is therefore in a position to define the relevant leakage current to the earth, so as to make it easy for the operators to subsequently intervene and restore a regular operation.

This requirement is presently met by carrying out manual measurements, by appropriate instruments and point by point, on the installation and/or apparatus on which possible current leakages are to be verified. Obviously this inspection is executed both as a preventive operation and in case of failure.

It is well apparent however that this manual procedure is arduous and only relies on the skill of a technician because the latter is entrusted with the task of interpreting the value shown on the instrument and finding out the faulty apparatus and/or installation point.

As regards exclusively safety, it is to be added that in normal wiring systems there is a protection device disposed downstream of the electric meter and usually named "tripping device" or "differential switch" which, when there is an anomalous current absorption by an apparatus or a sudden bad insulation, is released and causes the equipment isolation.

A typical case is that of a child that puts his fingers in a current socket and causes the tripper device to be released before a current arc between the socket and child is struck to the earth.

According to the provisions of law the whole electric system is to be grounded according to very precise technical modalities. However, no device exists that, in case of an anomalous absorption is capable of showing which of the apparatus and/or points in an electric system has caused a particular leakage current or, at all events, a faulty insulation.

Therefore it is presently impossible to have an immediate confirmation as regards the malfunction of a given apparatus when, as a result of the tripping device release, the feeding section of the wiring system to which said apparatus is also connected is isolated.

Consequently, in order either to quickly identify an anomalous operation of an apparatus or carry out a preventive inspection of the wiring system for ascertaining the compliance of same with the grounding rules, it becomes necessary to display and detect the value of the leakage currents.

As this requirement is not presently met, it is impossible to state the objective and realistic reliability level of an electric system.

Therefore, in order to solve this problem, assembling in a compact circuitry of detection means with selective current discrimination means associated with display elements has been envisaged, all of them being connected to the wiring system to be verified in order to enable an automatic visual communication of the occurrence, and therefore a quick detection of a possible anomalous point in the system or the presence of any faulty apparatus.

The present invention aims at eliminating the limits of the above described prior art, by providing a circuit device for visually signalling leakage currents from an electric system to earth, in which a current detecting circuitry has been provided which, connected to selective networks of current comparators in turn connected to displaying means, enables the value of an anomalous absorption current to be displayed and a specific installation section subjected to failure and/or a possible concerned apparatus to be detected.

The foregoing and further objects that will become more apparent in the course of the following description are achieved in accordance with the present invention by a circuit device for visually signalling leakage currents from an electric system to earth, as claimed in the appended first claim and the subsequent ones.

Advantageously, the above device may be also implemented, in an alternative embodiment thereof, as a portable device provided with a male plug and a female socket. By fitting the male plug in a socket of the installation, it is possible to display whether at that point there is an anomalous current absorption. The female socket can be connected to any apparatus of the installation for displaying the anomalous absorption of the apparatus itself, that is to say for finding out whether at that point there is a current leakage to earth.

Further features and advantages of the invention will be more fully understood from the detailed description of a preferred embodiment of a circuit device for visually signalling leakage currents from an electric system to earth, given hereinafter by way of non-limiting example with reference to the accompanying drawings, in which:
- Fig. 1 is a block diagram of the device of the present invention;
- Fig. 2 is a perspective view of an alternative embodiment of the device of the invention, in the form of a portable device.

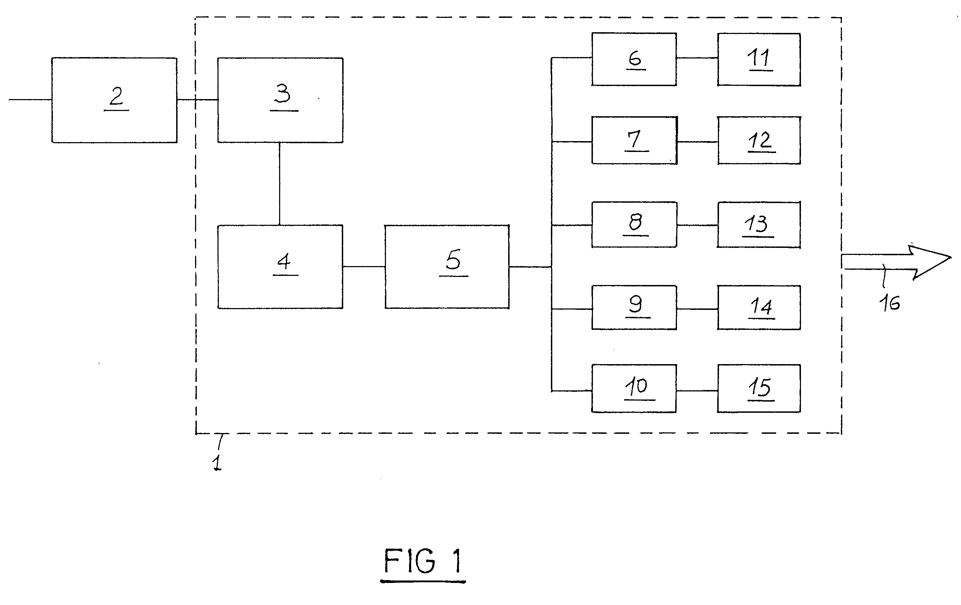

Referring to Fig. 1, the circuitry of a device in accordance with the present invention has been generally identified by reference numeral 1 and it has been enclosed with a broken line.

Said device 1 is usually wall-supported and it is installed in series downstream of a possible tripping device 2 connected in series upstream of the feeding line of the wiring system to which the tripping device belongs.

Obviously, if no tripping device is provided, the device of the invention can be installed all the same on the wiring system.

Connected in series on the line of the electric system and tripping device, if any, is a differential magnetic flux detector 3 comparing the magnetic flux interwound with the input conductor of the electric system feeding line and the magnetic flux interwound with the output conductor of the electric system feeding line. Said magnetic flux detector 3 essentially consists of a logic gate comparator generating a resulting current signal at the exit which is a function of the comparison between a current signal at the entry and a reference current signal, one of which is pre-established as a reference value for said comparison.

Said comparator circuit 3 is normally of the digital type and practically, in addition to the comparing circuitry proper, it comprises an interwinding coil which is put around each of the conductors of the feeding line in order to enable the above differential magnetic flux to be determined.

Sequentially with respect to the detector 3, there is a filter 4 enabling the line disturbance to be compensated for and a signal amplifier 5 located downstream to be protected against possible current peaks present on the line.

The amplifier 5 allows an amplification of the current signal to be achieved so that a correct interpretation of the amplified signal by a plurality of selective current discriminators may be reached.

Said selective discriminators consist each of a comparator 6, 7, 8, 9 and 10 comparing the resulting signal from the detector 3 and amplified by the amplifier 5, with a reference signal taken as a reference value according to the following selective scale of current absorptions:
- > 20 mA
- > 15 mA
- > 10 mA
- > 5 mA
- < 5 mA.

Briefly, by way of example only, the comparator 6 discriminates as far as 5 mA whereas the comparator 10 discriminates beyond 20 mA. All other intermediate comparators selectively discriminate the current values included within respective value ranges and becoming increasingly greater between these two extremes according to the above scale, with increments of 5 mA for example. Obviously, the above value scale is given by way of example only and may vary depending on the specific requirements.

Respectively associated with each of such comparators 6, 7, 8, 9, 10 is a luminous indicator consisting for example of a coloured reference LED (light-emitting diode) 11, 12, 13, 14 15, enabling the corresponding detected absorption value gap to be displayed.

Obviously the device 1 is grounded to 16 in order to enable a correct detection of the earth leakages.

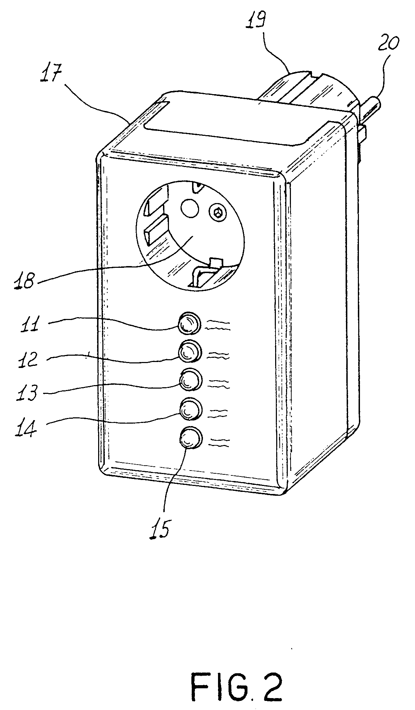

Referring now to Fig. 2, it is to be pointed out that in this case the circuit of the device 1 is enclosed in a casing 17 on which the LEDs 11, 12, 13, 14 and 15 are exposed.

Said casing 17 has a standardized male plug 10 provided with appropriate pins 20 in register with which, on the opposite side of the casing 17 (which position however is not binding) there is a standardized female socket 18.

The circuitry present within the casing 17 is connected in series with the socket 18 and the pins of the plug 19.

Operation of the device of the invention described above mainly as regards structure is as follows.

Referring to Fig. 1, it can be seen that the device is usually connected in series with an electric feeding line and through the detector 3 enables the differential magnetic flux to be detected, that is the difference between the incoming magnetic flux and the outgoing magnetic flux with respect to the corresponding feeding conductor of the line in question with which the device itself is connected.

Such a detection gives rise to the identification of any difference between the absorption at the entry and that at the exit of the feeding line.

The amount of said difference is correlated with the amount of the earth leakage. It is in fact to be noted that, being the incoming magnetic flux kept at a predetermined and constant value, any variations in the leakage current value will cause by effect of the resulting change in the outgoing magnetic flux, a variation in the above differential magnetic flux.

On varying of the differential magnetic flux, a variation in the current signal emitted from the detector 3 to the amplifier 5 occurs.

The amplified signal consequently emitted from the amplifier 5 is sent to the selective comparators 6, 7, 8, 9, 10, each of which causes the switching on of the corresponding luminous indicator 11, 12, 13, 14 and 15 only when the amplified signal takes a value corresponding to a leakage current falling within the range of absorption values specifically assigned to the comparator itself.

Therefore a selective switching on of the luminous indicators 11, 12, 13, 14 and 15 is carried out and, based on said selective switching on, it is possible to immediately detect the rough value of the leakage current both in case of normal operation and operation under abnormal conditions.

Thus, the amount of the detected leakage current already gives an indication of the type of possible inconvenience in the electric system and/or the type of apparatus responsible for earth leakages. By way of example, in fact, relatively high current leakage values are evidence of the presence of a short circuit in the electric equipment and/or apparatus operating with the mains voltage, whereas relatively low leakage values usually indicate anomalies occurred in apparatus operating at low current values.

It is therefore clear that the above described indications help a technician entrusted with servicing in identifying the cause of the earth leakage. In fact, just as an indication, a current leakage included between 5 and 10 mA can be considered as normal if heating resistors of the type used in washing machines, electric cookers and the like are connected with the electric system, which items have very low earth leakages.

Higher leakages, on the contrary, indicate abnormal situations of earth leakages that are to be corrected before a limit of about 30 mA is reached, which limit would cause the tripper device to be released.

The exact identification of the point in the electric system and/or the apparatus responsible for earth leakages can be carried out in a very easy manner by the alternative embodiment shown in Fig. 2. In fact, by fitting the male plug 19 in turn in the individual sockets provided in the installation, the value of the leakage current at each of the sockets is identified, and therefore the installation point or points responsible for possible anomalies can be exactly found out.

In addition each of the electric apparatus can be inspected by engaging the corresponding plug thereof into the socket 18 when the male plug 19 of the device 1 is fitted in one of the installation sockets. On insertion of the apparatus plug into the socket 18 of the device 1, the possible turning on of one of the luminous indicators 13, 14, 15 relating to high leakage values shows the presence of anomalies in the apparatus itself.

The present invention attains the intended purposes.

The device in question, when directly connected with the electric installation, gives a constant indication of the amount of the leakage currents present in the installation itself, and therefore enables to immediately verify whether or not said installation meets the provisions of law as regards earth leakages.

This feature represents an important advantage as compared to the known art, where the user becomes aware of possible earth leakages only when the tripping device cuts out the current supply in the whole wiring system and the amount of the leakage current has already exceeded the prescribed safety values. In addition, trying to find the cause of the earth leakage in the absence of current as a result of the intervention of the tripping device is a rather arduous and empiric procedure. In fact it is necessary to act on the distribution board associated with the electric system for disconnecting all apparatus and restore the current supply by means of the tripping device, and then sequentially reconnect the different system sections in order to find out which of them causes the tripping device to be released.

When the system section responsible for the earth leakage has been identified, it will be necessary to disconnect all apparatus connected to that section and sequentially reconnect them in the presence of current in order to find out which of them causes a new intervention of the tripping device.

It will be recognized that this procedure is rather long and arduous and in addition it is not devoid of danger, due to the repeated restoring of the current supply in the presence of short circuits with high current leakages to earth.

On the contrary, the device of the invention enables the presence and amount of the current leakage to be identified when said leakage is still below a safety threshold, without involging the intervention of the tripping device. The identification of the installation point and/or apparatus responsible for the earth leakage can be therefore carried out in a much easier, quicker and safer manner than in the known art, optionally with the aid of the alternative embodiment of the device shown in Fig. 2.

Obviously, modifications and variations may be made to the invention as conceived, all of them falling within the scope of the appended claims.

## Claims

1. A circuit device for visually signalling leakage currents from an electric system to earth, characterized in that it comprises a circuitry connected in series upstream of the conductors of the electric system feeding lines, said circuitry comprising a differential magnetic flux detector (3) for detecting the difference between the magnetic flux interwound with the input conductor of the electric system feeding line to which said detector (3) is connected and the magnetic flux interwound with the output conductor of the electric system feeding line to which said detector (3) is connected, said detector (3) being circuit connected in series to a plurality of selective current discriminators (6, 7, 8, 9, 10) associated with respective luminous indicators (11, 12, 13, 14, 15) for causing the switching on of the corresponding luminous indicator (11, 12, 13, 14, 15) associated with the selective current discriminator (6, 7, 8, 9, 10) in the selection scale of which the value of a leakage current determining the differential magnetic flux detected by said detector (3), is included.

2. A device according to claim 1, characterized in that said differential magnetic flux detector (3) comprises a logic gate comparator comparing an incoming current signal with a reference current signal and generating a resulting outgoing current signal, said resulting signal being a function of the leakage current determining said differential magnetic flux.

3. A device according to claim 2, characterized in that each of said selective current discriminators (6, 7, 8, 9, 10) comprises a selective comparator comparing the resulting signal generated by said differential magnetic flux detector (3) with a reference signal corresponding to a predetermined value range of said leakage current, said selective comparator (6, 7, 8, 9, 10) being designed to operate the switching on of one of said luminous indicators (11, 12, 13, 14, 15) when the leakage current value falls within the value range assigned to said selective comparator.

4. A device according to claim 1, characterized in that said differential magnetic flux detector (3) is connected to said selective current discriminators (6, 7, 8, 9, 10) by a signal amplifying circuit (5) connected in circuit downstream of a filter (4) for cutting the current peaks.

5. A device according to claim 3, characterized in that said selective comparators (6, 7, 8, 9, 10) are given respective value ranges increasingly growing according to a division scale having increments of 5 mA between each value range and the next one.

6. A device according to claim 1, characterized in that said luminous indicators (11, 12, 13, 14, 15) are coloured LEDs (light-emitting diodes).

7. A circuit device for visually signalling leakage currents from an electric system to earth, characterized in that it comprises a circuitry comprising a differential magnetic flux detector (3) for detecting the difference between the magnetic flux interwound with the input conductor of the electric system feeding line to which said detector (3) is connected and the magnetic flux interwound with the output conductor of the electric system feeding line to which said detector (3) is connected, said detector (3) being circuit connected in series to a plurality of selective current discriminators (6, 7, 8, 9, 10) associated with respective luminous indicators (11, 12, 13, 14, 15) for causing the switching on of the corresponding luminous indicator (11, 12, 13, 14, 15) associated with the selective current discriminator (6, 7, 8, 9, 10) in the selection scale of which the value of a leakage current determining the differential magnetic flux detected by said detector (3), is included, said device being enclosed in a casing (17) having a standardized male plug (19) connected in series with said differential magnetic flux detector (3).

8. A device according to claim 7, characterized in that said casing (17) also has a standardized female socket (18) connected in series with the differential magnetic flux detector (3).
